# EUROPEAN PATENT APPLICATION

(11) **EP 4 442 854 A1**
(43) Date of publication of application: **09.10.2024**
(21) Application number: 22900887.5
(22) Date of filing: 26.09.2022
(51) Int. Cl.: C23C 14/50, H01L 21/31, H01L 21/683

(54) **VACUUM PROCESSING DEVICE**

(30) Priority: 03.12.2021 JP 2021197302
(71) Applicant: ULVAC, Inc., Chigasaki-shi, Kanagawa 253-8543 (JP)
(72) Inventor: FUJINAGA, Tetsushi, Chigasaki-shi, Kanagawa 253-8543 (JP); NUMATA, Yukinobu, Chigasaki-shi, Kanagawa 253-8543 (JP); OOKUBO, Yasuo, Chigasaki-shi, Kanagawa 253-8543 (JP); SHIMADA, Daiki, Chigasaki-shi, Kanagawa 253-8543 (JP)
(74) Representative: Epping - Hermann - Fischer
(86) International application number: PCT/JP2022/035693
(87) International publication number: WO 2023/100452

(57) **Abstract**

Provided is a vacuum processing apparatus having a stage which is arranged to be capable of deviating a phase of a to-be-processed substrate without giving rise to a positional deviation thereof.

A vacuum processing apparatus (SM) of this invention having a stage (4) on which is disposed the to-be-processed substrate (Sw) further has a lifting/rotation mechanism (Rm) capable of lifting the to-be-processed substrate lying on the stage off from an upper surface of the stage to a predetermined height position so that, at this lifted position, the to-be-processed substrate is capable of rotation about a substrate center by a predetermined rotational angle. The lifting/rotation mechanism has: a driving rod (5) built into the stage so as to be moveable up and down and also be rotatable; and a substrate supporting body (6) having a base end plate part (61) capable of contacting a central region, including the substrate center, of the to-be-processed substrate. The substrate supporting body (6) further has at least two arm plate parts (62) elongated from the base end plate part outward thereof so as to be capable of contacting such a portion of the to-be-processed substrate as is lying diametrically. The substrate supporting body is ordinarily immersed into the stage so that the to-be-processed substrate is supported by such base end plate part and arm plate parts as are lifted by an upward movement of the driving rod.

## Description

### TECHNICAL FIELD

The present invention relates to a vacuum processing apparatus which is disposed inside a vacuum chamber and which is provided with a stage having installed thereon a substrate to be processed (hereinafter called "a to-be-processed substrate").

### BACKGROUND ART

In a manufacturing processing of a semiconductor device, various kinds of vacuum processing are performed on a processing surface (i.e., a surface to be processed) of a silicon wafer (called a "substrate"), by using a vacuum processing apparatus such as a vacuum deposition (i.e., vacuum film forming) apparatus and a dry etching apparatus, such as film deposition processing by CVD method, sputtering method, or vacuum deposition method, or dry etching processing. Inside the vacuum chamber of the vacuum processing apparatus there is ordinarily provided a stage having installed thereon a substrate. The stage has assembled therein various kinds of equipment such as an electrostatic chuck, a heating/cooling mechanism and the like so that, at the time of vacuum processing, the substrate can be electrostatically sucked or the substrate can be maintained at a predetermined temperature.

In the above-mentioned vacuum processing apparatus, the equipment inclusive of the stage on which the substrate is to be disposed (mounted) is assembled with a certain tolerance. However, it is difficult to assemble the vacuum processing apparatus in a point symmetry mechanically and electrically relative to the center of the substrate that is to be disposed on an upper surface of the stage. In addition, it is general practice that the flow of the processing gas to be introduced into the vacuum chamber is not in point symmetry relative to the center of the substrate but has a certain amount of deviation relative to the center of the substrate. In case film deposition is performed in this kind of state, e.g., by the sputtering method, there is a problem in that, due to non-symmetrical nature of the vacuum processing (film deposition) apparatus, deviation will occur in the in-plane film thickness distribution of the substrate. Taking this fact into account, it is known to rotate the substrate on the stage about the center thereof by a predetermined rotational angle (namely, by deviating the phase of the substrate in the circumferential direction), thereby performing the deposition processing stepwise (see, e.g., patent document 1).

In the above-mentioned known example, the film deposition processing is temporarily intermitted during the above-mentioned processing to thereby take out the substrate from the vacuum chamber to transfer it to another vacuum chamber. The substrate is rotated by a predetermined rotational angle inside the said another vacuum chamber, thereby deviating the phase. In this state, the substrate is set again on the stage of the original vacuum chamber to thereby resume the film deposition processing. Therefore, the productivity is considerably poor. As a solution, it is considered to assemble into the stage a substrate supporting body which is moveable up and down and rotatable to thereby deviate the phase of the substrate by using the substrate supporting body. However, if an arrangement is made such that the substrate supporting body is lifted by bringing the substrate supporting body into contact with the central region of the substrate, there will be a problem in that the substrate may give rise to a positional deviation at the time of lifting and rotating of the substrate supporting body (this problem will be more conspicuous with a substrate which is large in diameter and small in thickness, accompanied by the occurrence of a bow). In this kind of situation, an area of contact of the substrate supporting body with the substrate may be increased. However, in case the above-mentioned pieces of equipment are in a state of having been assembled, the area of contact cannot be increased much if an arrangement is made such that the function of sucking the substrate and the function of heating the substrate with good in-plane uniformity are not impaired.

### PATENT DOCUMENTS

Patent Document 1: JP2018-104738A

### SUMMARY OF THE INVENTION

### PROBLEMS THAT THE INVENTION IS TO SOLVE

In view of the above-mentioned points, this invention has a problem of providing a vacuum processing apparatus having a stage capable of rotating the to-be-processed substrate each time by a predetermined rotational angle about a substrate center without giving rise to the positional deviation of the to-be-processed substrate.

### MEANS FOR SOLVING THE PROBLEMS

In order to solve the above-mentioned problems, this invention is a vacuum processing apparatus comprising a stage which is disposed inside a vacuum chamber and on which is disposed a to-be-processed substrate. The vacuum processing apparatus further comprises a lifting/rotation mechanism which is capable of lifting the to-be-processed substrate lying on the stage off from an upper surface of the stage so that, at this lifted position, the to-be-processed substrate is capable of rotation about a substrate center by a predetermined rotational angle. The lifting/rotation mechanism comprises: a driving rod built into the stage so as to be moveable up and down and also be rotatable; and a substrate supporting body having a base end plate part capable of contacting a central region, including the substrate center, of the to-be-processed substrate. The substrate supporting body also has at least two arm plate parts elongated from the base end plate part outward thereof so as to be capable of contacting such a portion of the to-be-processed substrate as is lying diametrically. The substrate supporting body is ordinarily immersed into the stage so that the to-be-processed substrate is supported by such base end plate part and arm plate parts as are lifted by an upward movement of the driving rod.

In this invention, in case a chuck plate for an electrostatic chuck is disposed on a surface of contact of the stage with the to-be-processed substrate, preferably the chuck plate is provided, in a recessed manner, on its upper surface with a retracting space, so as to comply with a contour of the substrate supporting body, so as to enable for the substrate supporting body to be immersed thereinto such that, in a state in which the substrate supporting body is immersed, the upper surface of the substrate supporting body is flush with the upper surface of the chuck plate.

According to the above-mentioned arrangement, when the to-be-processed substrate is lifted by the substate supporting body out of contact with the stage, in addition to contacting the base end plate part with the substrate central region, the radially elongated arm plate part comes into contact with the central region of the substrate so as to support the to-be-processed substrate. Therefore, even if the to-be-processed substrate is small in thickness and large in diameter, there can materialize an arrangement in which the positional deviation hardly occurs at the time of lifting or rotation of the to-be-processed substrate. In this case, by making the arm plate part into a shape of relatively narrow width and elongated length and by appropriately setting the number of each arm plate part to be disposed at a predetermined distance from one another around the substrate plate part, when equipment such as the electrostatic chuck, and heating/cooling mechanism is assembled, the arm plate part can be disposed to stand clear of the chuck electrodes, heating heaters, and the like. In this manner, the function of being capable of electrostatically sucking the to-be-processed substrate or the function of maintaining the to-be-processed substrate at a predetermined temperature can be prevented from getting impaired. In addition, in a state in which the substrate supporting body is recessed, an arrangement has been made that the substrate supporting body is fitted into the retracting space of the chuck plate so as to be flush with the upper surface thereof. Therefore, for example, in case the bias potential is applied to the to-be-processed substrate during the vacuum processing, so-called bias irregularity can be prevented from occurring. By the way, when the arm plate part is set to be, e.g., two in number and is disposed around the substrate plate part at a clearance of 180 degrees, in case the to-be-processed substrate is small in thickness and large in diameter, there is a possibility that the positional deviation may occur at the time of lifting or rotation. In such a case, there may be disposed, e.g., subplate parts at the front end of the arm plate parts in rotation symmetry with each other.

### DESCRIPTION OF THE DRAWINGS

FIG. 1 is a schematic diagram illustrating a sputtering apparatus according to a first embodiment of this invention.
FIG. 2 is a plan view of a substrate supporting body illustrated in FIG. 1.
FIG. 3 is a diagram illustrating film deposition processing.
FIG. 4 is a plan view of a substrate supporting body according to a second embodiment of this invention.

### MODES FOR CARRYING OUT THE INVENTION

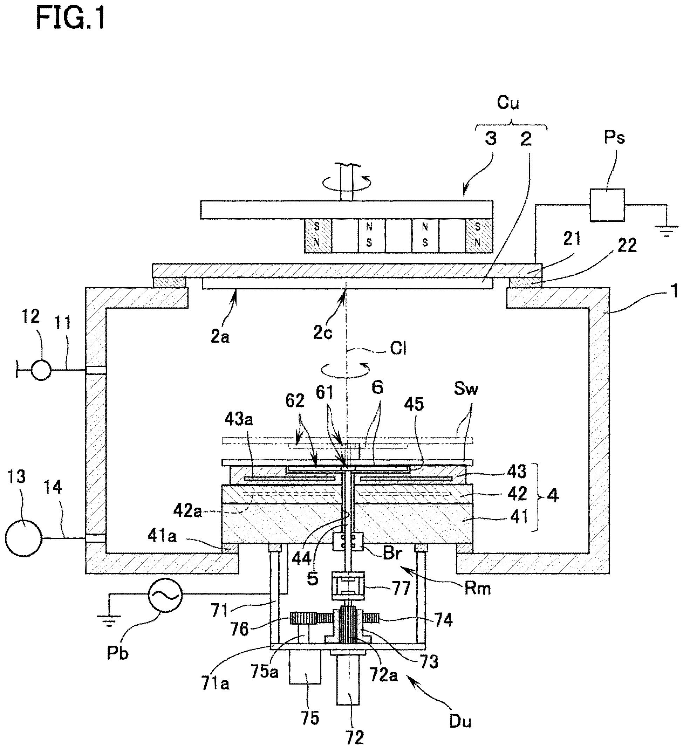

With reference to the figures, descriptions will now be made of a vacuum processing apparatus according to the first embodiment of this invention provided that the vacuum processing apparatus is a sputtering apparatus and the to-be-processed substrate is a silicon wafer (hereinafter called "a substrate Sw", or "a to-be-processed substrate Sw"). In the following descriptions the terms denoting the directions such as up (or upper), low (or lower), etc. shall be based on FIG. 1 illustrating the posture of installation of the sputtering apparatus.

With reference to FIG. 1, the sputtering apparatus SM is provided with a vacuum chamber 1. A side wall of the vacuum chamber has connected thereto a gas pipe 11 having interposed therein a massflow controller 12 as a flow control valve so that a sputtering gas whose flow amount is controlled can be introduced into the vacuum chamber 1. The side wall of the vacuum chamber 1 has further connected thereto an exhaust pipe 14 communicated with a vacuum pump 13 so that the vacuum chamber 1 can be exhausted down to (or up to) a predetermined vacuum degree. An upper part of the vacuum chamber 1 is detachably provided with a cathode unit Cu. The cathode unit Cu is constituted by: a target 2 made of a material depending on a thin film to be deposited on the substrate Sw; and a magnet unit 3 disposed above the target 2. The target 2 has applied thereto a backing plate 21 on a side opposite to a sputtering surface (i.e., surface to get sputtered) 2a. The outer peripheral portion of the backing plate 21 is attached to an upper wall of the vacuum chamber 1 through an electrically insulating body 22. Further, the target 2 has connected threreto an output of the sputtering power source Ps so that, depending on the kind of target, DC power supply with a negative electric potential or a high-frequency (AC) power supply of a predetermined frequency can be supplied. As the magnet unit 3 there may be used a known one which generates a leakage magnetic field in the space below the sputtering surface 2a. Therefore, detailed description thereof will be omitted in this specification.

At a lower portion of the vacuum chamber 1 there is concentrically disposed, in an opposed manner, a stage 4 positioned on a center line Cl passing through the center of the target 2c. The stage 4 has a base 41 which is disposed on an inner surface of the lower wall of the vacuum chamber 1 through an electrically insulating body 41a, the base 41 having an upper surface corresponding to the contour of the substrate Sw. The base 41 of metal make has formed therein a coolant circulation passage (not illustrated) which circulates cooling water so as to cool the substrate Sw. Further, the base 41 has connected thereto an output from a bias power supply Pb. It is thus so arranged that bias potential can be applied to the substrate Sw depending on the necessity during film deposition. An upper surface of the base 41 has disposed thereon a hot plate 42 and a chuck plate 43, both having a contour equivalent thereto. The hot plate 42 is constituted by disposing, between two metallic plate members of relatively high thermal conductivity, a sheath heater 42a in a predetermined pattern. By applying predetermined electric power to the sheath heater 42a from an electric power supply (not illustrated), the substrate Sw can be heated to a uniform temperature over an entire surface thereof. The chuck plate 43 is constituted by a dielectric body and is provided inside thereof with an electrode 43a, in a predetermined pattern, for the electrostatic chuck. When electric power is applied to the electrode 43a from an electric power source (not illustrated) for the electrostatic chuck, the substrate Sw can be electrostatically sucked by the electrostatic force that is generated at that time. Further, the stage 4 has built therein a lifting/rotation mechanism Rm which lifts the substrate Sw on the chuck plate 43 and which rotates the substrate Sw at the lifted position by a predetermined rotational angle about the center line C1.

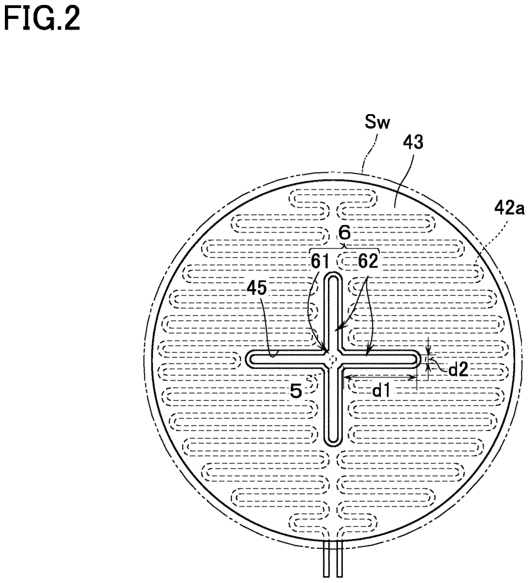

With reference also to FIG. 2, the lifting/rotation mechanism Rm is provided with a driving rod 5 and a substrate supporting body 6 which comes into contact with a rear surface of the substrate Sw. The stage 4 has formed, in a position of the center line C1, a retracting hole 44 which is elongated in the vertical direction by penetrating through the base 41, the hot plate 42 and the chuck plate 43. The retracting hole 44 has inserted threthrough a driving rod 5. The lower end of the driving rod 5 protrudes outside the vacuum chamber 1 through such a sealing means Br as is also serving the purpose of a bearing that is disposed in the base 41 like a magnetic fluid seal. This protruding part of the driving rod 5 has connected thereto a driving unit Du. The driving unit Du is provided with a supporting frame 71 which is suspended from the lower surface of the base 41. The supporting plate part 71a of the supporting frame 71 is provided with a lifting means 72 such as an air cylinder and a direct-drive motor which is provided with a driving shaft 72a which moves up and down along the center line C1. The driving shaft 72a is formed as a spline shaft, and is engaged with a ball spline nut 73 which is mounted on the supporting plate part 71a. On an outer peripheral surface of the ball spline nut 73 there is externally inserted therethrough a first gear wheel 74 so as to be in gear mesh with a second gear wheel 76 that is externally inserted onto a rotary shaft 75a of the rotary means 75 such as a stepping motor, etc. disposed in the supporting plate part 71a of the supporting frame 71. In this arrangement, the upper end of the driving shaft 72a is connected to the lower end of the driving rod 5 through an isolation member 77 which electrically isolates the driving shaft 72a and the driving rod 5. In case a film is deposited by applying bias electric potential to the substrate Sw, although not described by particularly illustrating, an electrically conductive member such as a brush is employed so that the lifting/rotation mechanism Rm becomes the same electric potential as the base 41.

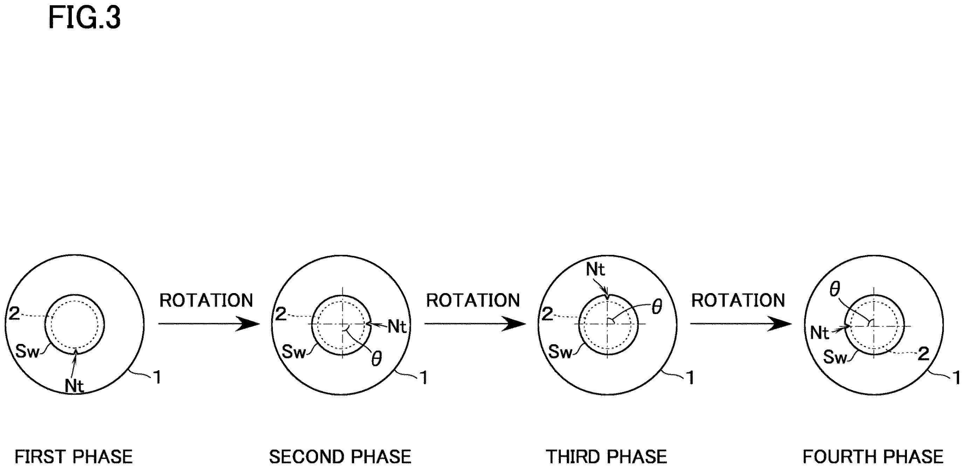

The substrate supporting body 6 has: a base end plate part 61 of a circular profile having its center on the center line Cl; and four arm plate parts 62 of a predetermined thickness, the arm plate parts 62 being disposed circumferentially along the periphery of the base end plate part 61 at an interval of 90 degrees and elongated linearly diametrically outward, so as to be formed into a cross-shaped profile (i.e., a shape like a cross) as a whole. The base end plate part 61 and the arm plate parts 62 may be formed, e.g., integrally of a material that is the same as the chuck plate 43. In this case, the upper surface of the chuck plate 43 has formed, in a recessed manner, a retracting space 45 coinciding with the profile of the substrate supporting body 6. The depth of the retracting space 45 is set such that, ordinarily, the substrate supporting body 6 becomes an immersed state of getting fitted into the retracting space 45 and that, at this time, the upper surface of the substrate supporting body 6 becomes flush (i.e., the same level) with the upper surface of the chuck plate 43. Each of the arm plate parts 62 is formed into a narrow slender shape of relatively small width. For example, the length d1 and the width d2 of each of the arm plate parts 62 and the number of the arm plate parts 62 to be disposed in the circumference of the base end plate part 61 are appropriately set depending on the pattern of the sheath heater 42a and the pattern of the electrode 43a for the electrostatic chuck (in other words, in a manner to stand clear of the projection regions formed by the projection of the sheath heater 42a and the electrode 43a). Then, depending on the length d1 and the width d2 of each of the arm plate parts 62, the area of the base end plate part 61, the plate thicknesses of the base end plate part 61 and the arm plate parts 62 are set appropriately such that positional deviations do not occur when the substrate Sw is lifted by the substrate supporting body 6 to a position of predetermined height and when the substrate Sw is rotated at the lifted position. Descriptions will now be made hereinbelow, with reference to FIG. 3, of the procedures of stepwise deposition of the thin film of a predetermined thickness of a targeted (goal) film thickness on the surface of the substrate Sw by using the above-mentioned sputtering apparatus SM.

Ordinarily, the substrate supporting body 6 is in a position immersed into the retracting space 45. In this state the substrate Sw is placed in position on the chuck plate 43 by a transfer robot (not illustrated) such that the substrate Sw is in a posture in which the notch Nt looks downward as seen in FIG. 3 (hereinafter, this state is called a "first phase"). In this state, the base end plate part 61 of the substrate supporting body 6 and the four arm plate parts 62 will be in a state of being in contact with the rear surface of the substrate Sw. When electric power is supplied to the electrode 43a, the substrate Sw will be electrostatically sucked to the upper surface of the chuck plate 43. Once the substrate Sw is electroctatically sucked to the chuck plate 43, the sheath heater 42a is supplied with electric power so as to start the heating of the substrate Sw by means of the hot plate 42. Then, once the vacuum chamber 1 has been evacuated inside thereof down to a predetermined pressure and also once the substrate Sw has been heated to a predetermined temperature, the sputtering gas (inclusive of a rare gas and a reactive gas for electric discharging) is introduced into the vacuum chamber 1 at a predetermined flow rate, and the target 2 is supplied with electric power by the sputtering power source Pb. Depending on the necessity, the substrate Sw is supplied with bias electric potential by the bias power supply Pb through the base 41. According to these operations, the sputtering surface of the target 2 (i.e., that surface of the target 2 which is to be sputtered) gets sputtered so that the sputtered particles to be splashed from the sputtering surface 2a get adhered to, and deposited on, the surface of the substrate Sw. At this time out of the deposition rate to be obtained by the sputtering conditions such as the electric power to be supplied, the pressure inside the vacuum chamber 1 at the time of film deposition, and the like, the sputtering time is calculated so that the film deposition is performed at the film thickness of one-fourth (1/4) the goal film thickness.

Once the film deposition in the first phase has been finished, the introduction of the sputtering gas, and the electric power supply to the target 2 and the electrodes 43a are once stopped. In this case, the operation of the vacuum pump 13 will not be stopped but the vacuum chamber 1 will be maintained inside thereof in the vacuum atmosphere. When the electric power supply to the electrode 43a is stopped, the substrate Sw on the chuck plate 43 will be antistatically eliminated by a known method. Once the substrate Sw has been antistatically eliminated, the substrate supporting body 6 is moved upward by the lifting means 72. Then, as a result of being supported by those base end plate part 61 of the substrate supporting body 6 and the four arm plate parts 62 which are projected from the retracting space 45 upward, the substrate Sw is lifted to a lifted position (the position shown by two-dot chain lines in FIG. 1) above the chuck plate 43. Then, by the operation of the rotary means 75 the substrate supporting body 6, and finally the substrate Sw will be rotated 90 degrees about the center line Cl, and the substrate supporting body 6 is moved downward by the lifting means 72. At this time, the base end plate part 61 and the four arm plate parts 62 of the substrate supporting body 6 get fitted once again with the retracting space 45. In the second phase in which the notch Nt of the substrate Sw looks to the right in FIG. 3, the substrate Sw will be placed in position once again on the chuck plate 43. Then, a film is deposited on the substrate Sw of the second phase to a film thickness of one-fourth (1/4) the goal film thickness in the same procedure as above. By forming films in these procedures on the substrate Sw in the third and the fourth phases, predetermined thin film is formed on the surface of the substrate Sw to the goal film thickness.

According to the above-mentioned first embodiment, at the time of lifting and rotation of the substrate Sw, the substrate Sw is supported in a state in which each of the arm plate parts 62, in addition to the base end plate part 61, is in contact with the substrate Sw. Therefore, even if the substrate Sw is smaller in plate thickness and larger in diameter, an arrangement can be attained in which the positional deviation of the substrate Sw can hardly occur. In addition, since the substrate supporting body 6 is arranged to have a profile of cross-shape so as to be disposed to stand clear of the electrodes 43a of the electrostatic chuck and the sheath heater 42a of the substrate heating, there can be impaired no function of electrostatically sucking the substrate Sw or of maintaining the substrate Sw at a predetermined temperature. In addition, in a state in which the substrate supporting body 6 has been immersed, the substrate supporting body 6 is fitted with the retracting space 45 of the chuck plate 43 so as to be flush with the upper surface thereof. Therefore, even if the bias potential is applied to the substrate Sw, there can be restrained the so-called bias irregularities from taking place.

Descriptions have so far been made of the first embodiment of this invention, but this invention shall not be limited to the first embodiment. As far as the technical concept of this invention is not deviated in scope, various modifications are possible. In the above-mentioned first embodiment, descriptions were made by citing a sputtering apparatus SM as an example of a vacuum processing apparatus, but it is not necessary to limit it to the above. In performing the vacuum processing, should deviations occur to the vacuum processing of the substrate Sw because the processing surface of the substrate Sw (i.e., such a surface of the substrate as is to be processed) is inclined relative to the upper surface of the stage 4, this invention can be widely applicable to other processing apparatus such as a vacuum deposition apparatus, a dry etching apparatus, and the like.

Further, in the above-mentioned first embodiment, descriptions have been made of an example in which the substrate supporting body 6 has a cross-shaped profile, but this invention shall not be limited to the above. Depending, for example, on the substrate Sw (its plate thickness and size) to be subjected to vacuum processing, and depending on the rotational angle of the substrate Sw at the time of film deposition (number of phases), the arm plate parts 62 need be at least two, or else, the arm plate parts 62 may be arranged to be three (for example, three arm plate parts 62 are disposed at an interval of 120 degrees) so as to support the substrate at three points. Still furthermore, the arm plate parts 62 may be arranged to be above 5 pieces. It should however be noted that, in case vacuum processing is carried out by supplying bias potential to the substrate Sw, it is necessary to arrange that each of the arm plate parts becomes rotation-symmetry in any of the phases of the substrate Sw so that the substrate supporting body 6 attains the immersed state in which the substrate supporting body 6 gets fitted with the retracting space 45.

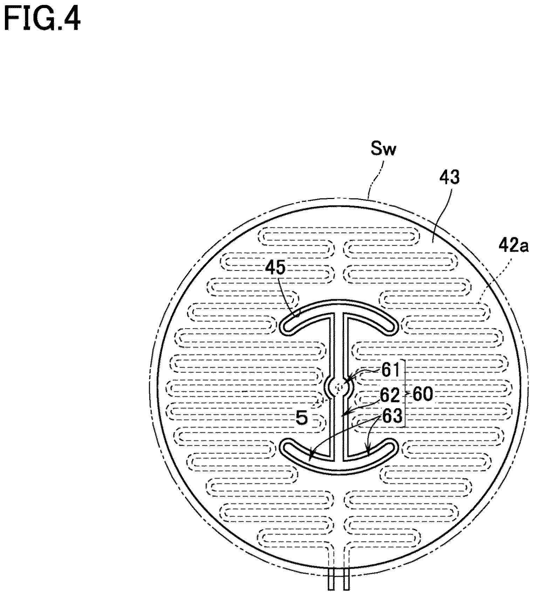

For example, if two arm plate parts 62 are disposed at, e.g., an interval of 180 degrees, there is a possibility that the substrate Sw may give rise to positional deviations at the time of lifting or rotation of the substrate Sw. As a solution, as in the second embodiment illustrated in FIG. 4, there may be disposed arch-shaped sub-arm plate parts 63 at a front end of each of the arm plate parts 62 of the substrate supporting body 60 in a manner to extend circumferentially both sides. The position of mounting the sub-arm plate parts 63 on each of the arm plate parts 62, the number and the shape thereof need not be limited to the above. But preferably each of the arm plate parts 62 inclusive of the sub-arm plate parts 63 shall be of rotation-symmetry with one another. Further, those surfaces of the arm plate parts 62 or the sub-arm plate parts 63 which come into contact with the substrate Sw may be subjected to roughening-working so as to increase their friction resistances. Still furthermore, in the above-mentioned embodiments, descriptions were made of examples in which the lower end of the driving rod 5 is rotatably supported through sealing means Br which also serves the dual purpose of a bearing. It is not necessary to limit the invention to the above as long as the lifting and rotation of the driving rod 5 are possible inside the vacuum chamber in vacuum atmosphere. For example, the known method such as bellows tube may also be employed.

### EXPLANATION OF MARKS

- SM: sputtering apparatus (vacuum processing apparatus)
- Sw: substrate (to-be-processed substrate)
- 4: stage
- 43: chuck plate
- 45: retracting space
- Rm: lifting/rotation mechanism
- 5: driving rod
- 6: substrate supporting body
- 61: base end plate part
- 62: arm plate part

## Claims

1. A vacuum processing apparatus comprising a stage which is disposed inside a vacuum chamber and on which is disposed a to-be-processed substrate, the vacuum processing apparatus further comprising a lifting/rotation mechanism which is capable of lifting the to-be-processed substrate lying on the stage off from an upper surface of the stage so that, at this lifted position, the to-be-processed substrate is capable of rotation about a substrate center by a predetermined rotational angle;
wherein the lifting/rotation mechanism comprises: a driving rod built into the stage so as to be moveable up and down and also be rotatable; and a substrate supporting body having a base end plate part capable of contacting a central region, including the substrate center, of the to-be-processed substrate, the substrate supporting body also having at least two arm plate parts elongated from the base end plate part outward thereof so as to be capable of contacting such a portion of the to-be-processed substrate as is lying diametrically;
wherein the substrate supporting body is ordinarily immersed into the stage so that the to-be-processed substrate is supported by such a base end plate part and arm plate parts as are lifted by an upward movement of the driving rod.

2. The vacuum processing apparatus according to claim 1, further comprising a chuck plate for an electrostatic chuck, the chuck plate being disposed on a surface of contact of the stage with the to-be-processed substrate,
wherein the chuck plate is provided, in a recessed manner, on its upper surface with a retracting space, so as to comply with a contour of the substrate supporting body, enabling for the substrate supporting body to be immersed thereinto such that, in a state in which the substrate supporting body is immersed, the upper surface of the substrate supporting body is flush with the upper surface of the chuck plate.
